# EUROPEAN PATENT SPECIFICATION

(11) **EP 4 295 404 B1**
(45) Date of publication and mention of the grant of the patent: **18.09.2024**
(21) Application number: 21707671.0
(22) Date of filing: 22.02.2021
(51) Int. Cl.: H01L 25/075, H01L 33/00, B41J 2/21

(54) **APPARATUS, SYSTEM AND METHOD FOR CURING INK PRINTED ON A SUBSTRATE**
VORRICHTUNG, SYSTEM UND VERFAHREN ZUM HÄRTEN VON AUF EINEM SUBSTRAT GEDRUCKTER TINTE
APPAREIL, SYSTÈME ET PROCÉDÉ DE DURCISSEMENT D'ENCRE IMPRIMÉE SUR UN SUBSTRAT

(43) Date of publication of application: 27.12.2023
(73) Proprietor: Applied Materials, Inc., Santa Clara, California 95054 (US)
(72) Inventor: CELLERE, Giorgio, 36040 Torri di Quartesolo (IT); FURIN, Valentina, 31100 Treviso (IT); NG, Hou T., Campbell, California 95008 (US); BIGOLIN, Andrea, 31020 Villorba (TV) (IT); MACCARI, Andrea, 31020 Villorba (TV) (IT)
(74) Representative: Zimmermann & Partner Patentanwälte mbB
(86) International application number: PCT/EP2021/054321
(87) International publication number: WO 2022/174932

(56) References cited:
- WO-A1-2016/014690
- US-A1- 2020 365 774
- US-B1- 10 522 709

## Description

### FIELD OF INVENTION

The present invention relates to the field of display manufacture, particularly in the field of providing a substrate for use in display applications. More particularly, the present invention relates to apparatuses and methods for curing a curable substance on the substrate.

### BACKGROUND

In display manufacture, several techniques are known to provide displays with improved resolution and contrast characteristics and many approaches have been developed. Where LCDs (liquid crystal display) use light-modulating properties of liquid crystals for influencing light provided by a backlight source or reflector to produce images in color or monochrome, the technique of OLED (organic light-emitting diode) displays provides organic materials directly emitting visible light in response to an electric power.

OLED displays are known to have beneficial effects in contrast to LCDs. For example, thinner and lighter displays can be provided, OLED displays achieve deeper black levels and a higher contrast ratio as well as are flexible and transparent, thus allowing the use of OLED displays in multiple applications like screens, TVs, smartphones, etc.

The generation of OLED substrates is typically carried out by coating an organic material onto a substrate, the organic material providing the primary colors red, blue and green to generate pixels on the substrate. The coating processes can be e.g., based on the evaporation of organic materials such as a host material and dopant materials, being deposited on the substrate, to provide for the differently colored pixel on the substrate.

In contrast to OLED technology, microLEDs (light-emitting diodes) can provide microscopic small pixels on a substrate, the microLEDs being made of inorganic materials, e.g. indium gallium nitride (InGaN), provided as semiconductor arrays, the microLEDs being capable of self-emitting light in response to an electric power. The microLED technology can be beneficial compared to the OLED technology as regards display manufacture as regards to e.g., the lifetime, brightness and contrast of the resulting displays. So far, manufacture of microLED arrays suitable for display manufacture has been expensive and inefficient. Furthermore, the provision of colored pixels is challenging.

WO 2016/014690 A1 describes an ink composition, which once printed and cured forms an organic thin film on a substrate such as an OLED device substrate. An UV curing module can include one or more enclosed UV curing chambers. A first radiation source (e.g., an ultraviolet-emitting LED array) can provide ultraviolet emission. US 10,522,709 B1 describes that a layer of photo-sensitive polymer is deposited on a light emitting surface of each of a plurality of LEDs. A voltage difference is applied across the electrodes of each LED, causing the operational LEDs to emit light and selectively cure the layers of photo-sensitive polymer. As such, a cured elastomer layer on the LED is formed on each operational LED due to the light emitted from the LED curing the layer of photo-curable polymer deposited thereon. On the other hand, non-operational LEDs will not emit sufficient light to cure the photo-curable polymer to form an elastomer layer. The uncured photo-curable polymer is washed away, such that the operational LEDs will have an elastomer layer, while non-operational LEDs will not have an elastomer layer. A pick-up tool (PUT) picks up LEDs by attaching to the LEDs via the elastomer layer. As such, the PUT picks up the operational LEDs, and leaves behind the non-operational LEDs. The operational LEDs may be placed onto a display substrate, or on an intermediate carrier substrate to form a known good die of operational LEDs. US 2020/365774 A1 describes that a method of fabricating a multi-color display includes dispensing a photo-curable fluid that includes a color conversion agent over a display having a backplane and an array of light emitting diodes electrically integrated with backplane circuitry of the backplane, activating a plurality of light emitting diodes in the array of light emitting diodes to illuminate and cure the first photo-curable fluid to form a color conversion layer over each of the first plurality of light emitting diodes to convert light from the plurality of light emitting diodes to light of a first color, and removing an uncured remainder of the first photo-curable fluid. This process is repeated with a fluid having different color conversion components for another color.

In light of the above, it is beneficial to provide improved apparatuses, systems and methods for microLED and display manufacture.

### SUMMARY

According to the present invention an apparatus including a light-sealable housing for curing light-curable ink printed on a substrate having light emitting diodes (LEDs) is provided. The apparatus includes a substrate support, an interface for supplying power to the LEDs and a transfer device. The transfer device is configured to change a relative position of the interface and the substrate support. The transfer device is configured to bring the interface into contact with the substrate for providing the power to the LEDs for illuminating the LEDs to cure the light-curable ink.

According to an aspect, a system for processing a substrate having light emitting diodes (LEDs) is provided. The system includes a printing section for providing a light-curable ink to the substrate, and an apparatus according to embodiments described herein.

According to a further aspect, a method for curing light-curable ink on a substrate having light emitting diodes (LEDs) is provided. The method includes providing an interface for supplying power to the LEDs, providing the substrate having the LEDs to a substrate support, changing a relative position of the interface and the substrate support using a transfer device, contacting the LEDs with the interface, providing a cooling gas for stabilizing a temperature, supplying power to the interface for illuminating the LEDs, and curing the light-curable ink on the substrate. The transfer device brings the interface into contact with the substrate for providing the power to the LEDs for illuminating the LEDs to cure the light-curable ink.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the present disclosure are also directed at methods for operating the described apparatus. It includes method aspects for carrying out every function of the apparatus.

### BRIEF DESCRIPTION OF THE DRAWINGS

So that the manner in which the above recited features of the present invention can be understood in detail, a more particular description of the disclosure, briefly summarized above, may be had by reference to embodiments. The accompanying drawings relate to embodiments of the disclosure and are described in the following:
- FIG. 1: shows a perspective view of an apparatus according to embodiments described herein;
- FIG. 2: shows a backside view of an apparatus according to embodiments described herein;
- FIG. 3: shows a front view of an apparatus according to embodiments described herein;
- FIGs.4A and 4B: show a perspective view of an apparatus according to embodiments described herein;
- FIG: 5: shows schematically a system according to embodiments described herein; and
- FIG. 6: shows a flow diagram of a method according to embodiments described herein.

### DETAILED DESCRIPTION OF EMBODIMENTS

Reference will now be made in detail to the various embodiments of the present invention, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

Within the following description of the drawings, the same reference numbers refer to the same or similar components. Generally, only the differences with respect to the individual embodiments are described. Unless specified otherwise, the description of a part or aspect in one applies to a corresponding part or aspect in another embodiment as well.

Light-curable ink can be used in a wide range of applications and can be particularly beneficial in the manufacture of displays, particularly of displays having light emitting diodes (LEDs) for providing single illuminable pixels throughout the display. For example, microLEDs, also known as µ-LEDs, MLEDs and/or mLEDs, i.e. single LEDs being microscopically small, can be beneficial as regards the manufacture of displays with high contrast, fast response time, improved color reproduction and energy efficiency as well as an improved lifetime compared to other display techniques such as LCD (liquid crystal display) or OLED (organic light emitting diodes).

In the resulting displays, each pixel represents one microLED providing a primary color, i.e. red, green or blue, and each of the pixels can be selectively controlled to generate a color representation of interest, i.e. a combination of illuminated pixels for generating a picture. For generating the pixels, light-curable ink may be used, i.e. the ink can be provided by e.g, printing it onto a substrate having microLEDs and the ink can be fixated thereon afterwards. Accordingly, each pixel may be generated by using a differently colored ink provided to the substrate and onto the microLED.

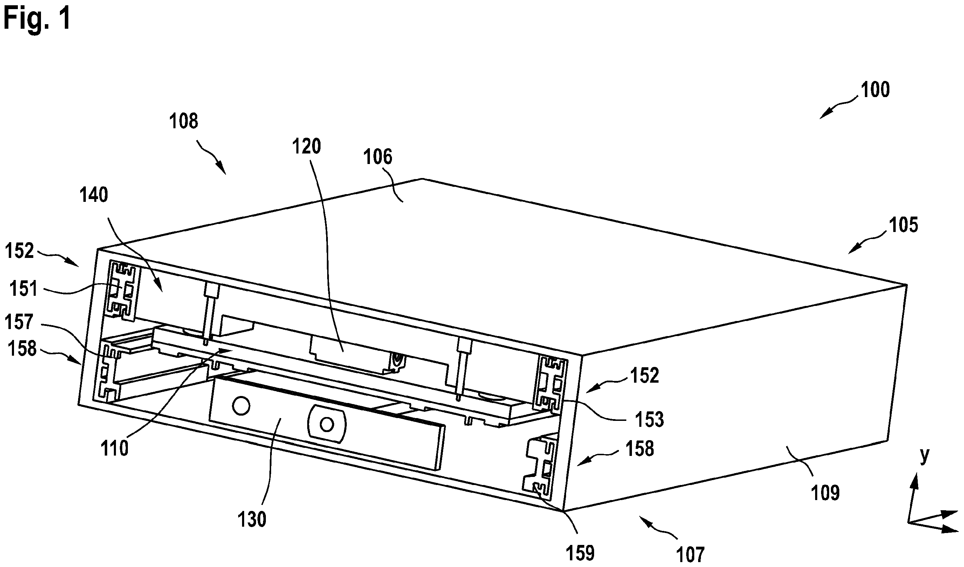

According to embodiments that can be combined with any other embodiment described herein and as exemplarily shown in FIG. 1, an apparatus 100 for curing light-curable ink printed on a substrate 10 having light emitting diodes (LEDs) is provided. The apparatus includes a light-sealable housing 105. The apparatus further includes an interface 110 for supplying power to the LEDs. The apparatus further includes a substrate support 130 and a transfer device 120 for changing a relative position of the interface and the substrate support 130. The transfer device is configured to bring the interface 110 into contact with the substrate 10 for providing the power to the LEDs for illuminating the LEDs to cure the light-curable ink.

According to embodiments that can be combined with any other embodiment described herein, the light-sealable housing 105 may include two side walls, i.e. a first side wall 108 and a second side wall 109, the second side wall 109 opposing the first side wall or vice versa, a top wall 106 and a bottom wall 107. The light-sealable housing 105 may border the interface, the transfer device, the substrate support and, when the substrate is loaded into the apparatus, the substrate. The light-sealable housing may include inner walls, particularly two inner side walls, an inner top wall and an inner bottom wall. The inner walls may be colored, particularly, the inner walls may be colored in an achromatic color, in particular in black (hex triplet: #000000; sRGB: (0, 0, 0) CMYK: (0, 0, 0, 100)), i.e. the light-sealable housing may include inner walls of black color, to absorb radiation and to avoid, i.e. absorb, stray radiation occurring from, e.g. illuminating the LEDs. In other words, the inner walls of the apparatus may be configured to disallow reflection of light emitted from the LEDs hitting the inner walls. It is to be understood that the walls may include a dark color, i.e. a color that slightly deviates from black, e.g. a dark gray or other color that may include little or no light reflection capacity.

Advantageously, stray radiation of the LEDs can be avoided and/or prevented. Thus, unspecific curing can be avoided or reduced. Accordingly, curing efficiency can be improved and higher yields can be achieved.

According to embodiments that can be combined with any other embodiment described herein, the apparatus may further include a mounting area 140 for providing a support for the interface 110 and/or the transfer device 120. In particular, the transfer device 120 and/or the substrate support 130 may be provided at the mounting area 140 and the interface 110 may be connected to the transfer device 120 and/or the substrate support 130. The transfer device 120 may be configured to bring the interface into contact with the substrate, e.g. the transfer device may be configured to bring the interface and the substrate in contact, thus providing power to the LEDs for illuminating the LEDs to cure the light-curable ink. The transfer device may provide a movement to the interface and/or the substrate support, e.g. the transfer device may move the interface up and down, i.e. in a direction towards the top wall of the apparatus and/or in a direction towards the bottom wall of the apparatus. In other words, the transfer device may provide a translational movement to the interface and/or the substrate in a vertical direction (along a distance in y-direction as shown in FIG. 1). Additionally, or alternatively, the transfer device may provide a horizontal movement to the interface and/or the substrate support for aligning the interface and the substrate. Accordingly, the transfer device may move the interface along a distance in z-direction as shown in FIG. 1.

The terms "vertical" or "horizontal" as used herein may include orientations including small deviations from exact verticality or horizontality, e.g. an angle of up to 10° or even 15° may exist compared to an exact vertical or exact horizontal direction.

Additionally, or alternatively, the transfer device may be configured to move the substrate support 130. The transfer device may move the substrate support to align the interface and the substrate. The interface may be stationary. The transfer device may be configured to move the substrate support in vertical and/or in a horizontal direction to align the substrate and the interface.

According to embodiments that can be combined with any other embodiment described herein, the interface is configured to provide power to the LEDs on the substrate. The interface may be connected to a power supply. The interface may include electrically conducting structures to be connected to the substrate, in particular to be connected to the LEDs on the substrate to provide power to the LEDs. For example, the interface may include a kit of plates including a probe card for contacting the LEDs. Dimensions of the interface may correspond to dimensions of the substrate. Alternatively, the dimension of the interface may exceed the dimension of the substrate. The power provided to the LEDs may include a voltage limited to ≤ 5 V and/or a current in the range of 10 to 100 mA in constant current mode.

According to embodiments that can be combined with any other embodiment described herein, the apparatus may include a first sliding opening and closing mechanism 152 and/or a second sliding opening and closing mechanism 158. Each of the first sliding opening and closing mechanism 152 and the second sliding opening and closing mechanism 158 may include a first track 151, 157 and a second track 153, 159. The first sliding opening and closing mechanism 152 and the second sliding opening and closing mechanism 158 may be arranged at the first side wall 108 and the second side wall 109 of the apparatus. Particularly, the first track 151, 157 and the second track 153, 159 may be arranged at the first side wall 108 and the second side wall 109 of the apparatus. In particular, the first track 151, 157 may be arranged at the first side wall 108 and the second track 153, 159 may be arranged at the second side wall 109 opposing the first side wall or vice versa.

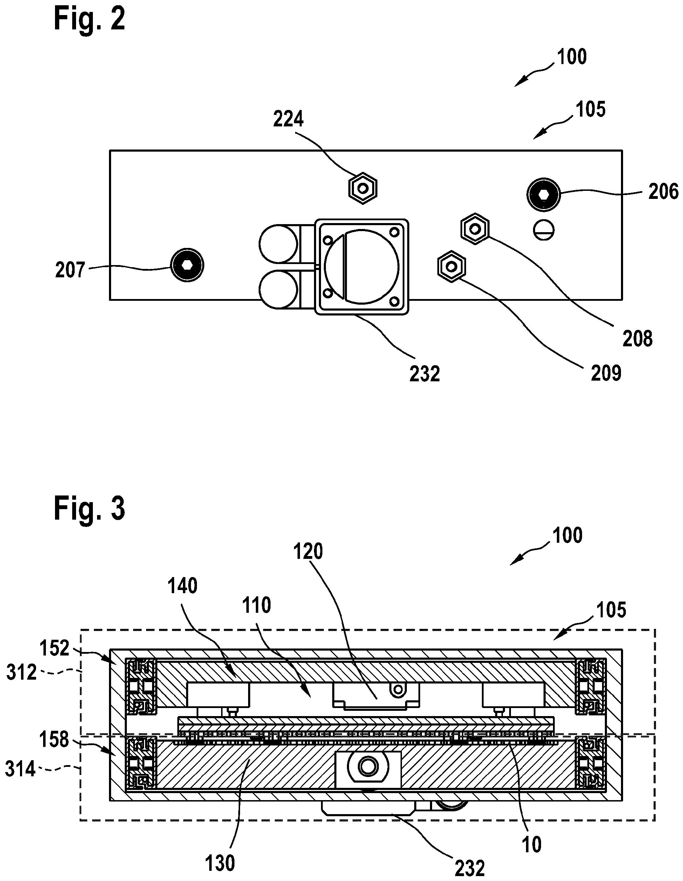

According to embodiments that can be combined with any other embodiment described herein and as exemplarily shown in FIG. 2, the apparatus may include a temperature control element for regulating a temperature inside the apparatus. A cooling, particularly an active cooling, may be provided inside the apparatus. The temperature control element may include a cooling plate and/or a cooling gas conduit. For example, a cooling gas may be provided to the apparatus 100 via the cooling gas conduit. The cooling gas conduit and/or the light-sealable housing 105 may include a gas inlet 206 for providing the cooling gas to the apparatus. Particularly, the cooling gas can be an inert gas, e.g. nitrogen (N₂). The cooling gas conduit and/or the light-sealable housing may further include a gas outlet 207 for removing the cooling gas from the apparatus. Accordingly, the cooling gas may circulate through the apparatus, e.g. fresh cooling gas may be continuously provided through the gas inlet to the apparatus and gas from the apparatus may be continuously removed through the gas outlet. The gas inlet and the gas outlet may be arranged at a rear side of the apparatus.

According to embodiments that can be combined with any other embodiment described herein, inside the apparatus, a shower head may be provided. The shower head may be connected to the gas inlet 206 to provide the cooling gas inside the apparatus. The shower head may distribute the cooling gas uniformly inside the apparatus. For example, the shower head may include one or more openings, particularly one or more nozzles, for distributing the cooling gas inside the apparatus.

According to embodiments that can be combined with any other embodiment described herein, the apparatus may include a cooling plate for regulating a temperature inside the apparatus. The cooling plate may be configured to provide a temperature to the apparatus, e.g. the cooling plate may include a conduit to provide a cooling gas or a cooling fluid for cooling the cooling plate and thus, the apparatus, i.e. the inside of the apparatus.

According to embodiments that can be combined with any other embodiment described herein, a constant temperature may be provided inside the apparatus 100. The apparatus may include a temperature control. The temperature control may control a temperature of the cooling plate and/or the cooling gas conduit, i.e. the temperature of the cooling gas provided to the cooling gas conduit, a flow rate of the cooling gas and/or an amount of cooling gas provided to the apparatus, i.e. the cooling gas conduit. Particularly, the constant temperature may be provided by providing the cooling gas. For example, the constant temperature may be in a range of 15°C to 40 °C, particularly in a range of 20 °C to 35 °C, more particularly in a range of 25 °C to 30 °C. Advantageously, temperature variation can be minimized, curing conditions may be more uniform and overheating of the components provided in the apparatus can be avoided or prevented.

According to embodiments that can be combined with any other embodiment described herein, the cooling gas may provide an inert atmosphere, i.e. an inert gas atmosphere inside the apparatus. The cooling gas may be an inert gas. Advantageously, the apparatus may maintain an inert atmosphere, i.e. an inert gas atmosphere inside the apparatus, during curing of the light-curable ink provided on the substrate. Thus, generation of side products, e.g. free radicals contaminating or negatively impairing the curing process, can be prevented and/or avoided. Furthermore, a stable and controlled temperature can be provided inside the apparatus to further stabilize the curing process.

According to embodiments that can be combined with any other embodiment described herein, the apparatus may be evacuated. The apparatus 100, i.e. the light-sealable housing 105 may include a vacuum feeding system including a vacuum pump for establishing vacuum conditions to the apparatus. For example, the light-sealable housing 105 may include a first port 208 and a second port 209 for vacuum feeding the apparatus. The first port and the second port may be arranged at the rear side of the apparatus.

According to embodiments that can be combined with any other embodiment described herein, the first sliding opening and closing mechanism and/or the second sliding opening and closing mechanism may include an actuator 232, e.g. a motor, for actuating the first and second opening and closing mechanism. The actuator 232 may be arranged at the rear side of the apparatus 100. The actuator may drive the first sliding opening and closing mechanism and/or the second sliding opening and closing mechanism. The first sliding opening and closing mechanism and the second sliding opening and closing mechanism may be driven independently.

According to embodiments that can be combined with any other embodiment described herein and also referring back to FIG. 1, the apparatus includes the transfer device. The transfer device may be selected from the group consisting of a piston and a short stroke cylinder. Particularly, the short stroke cylinder may be a pneumatic short stroke cylinder. The transfer device may be driven mechanically, hydraulically, pneumatically, electrically and/or by combinations thereof. The apparatus may include a feeding port 224, e.g. a pneumatic feeding port, for allowing the transfer device to move, i.e. for allowing the pneumatic short stroke cylinder to move. The feeding port 224 may allow the provision of energy to the transfer device for providing the movement to the transfer device and to change a relative position of the interface and the substrate support. The transfer device may be connected to the interface and/or the substrate support inside the apparatus. For example, particularly when the transfer device is driven pneumatically, e.g. when the transfer device is a pneumatic short stroke cylinder, through the feeding port 224, compressed air may be provided to the transfer device for providing the movement to the transfer device resulting in changing the relative position of the interface and the substrate support.

According to embodiments that can be combined with any other embodiment described herein, the transfer device may be a pneumatic short stroke cylinder. For example, the pneumatic short stroke cylinder, when applying compressed air, may provide a 5 mm stroke to move the interface to the substrate for contacting the substrate, particularly to contact the LEDs on the substrate.

According to embodiments that can be combined with any other embodiment described herein and exemplarily referring to FIG. 3, the apparatus may include a first chamber 312 and a second chamber 314. In FIG. 3, the first chamber and the second chamber are depicted with dashed lines. It is to be understood that the chamber may only reach to the first side wall, the second side wall and the top wall or the bottom wall of the light-sealable housing 105 but for reasons of clear depiction, the dashed lines exceed the light-sealable housing in FIG. 3. The term "chamber" as used herein may be understood as a non-closed compartment, i.e. as a defined space that is not completely surrounded by e.g., walls for allowing a fluid connection between various chambers. Particularly, the chamber, i.e. the non-closed compartment may be free from a bottom wall or a top wall to allow interaction of components arranged inside the chambers, particularly a movement of the components arranged inside the chambers in a vertical direction.

According to embodiments that can be combined with any other embodiment described herein, in the first chamber 312, the transfer device 120, the interface 110 and the first sliding opening and closing mechanism 152 may be arranged. In the second chamber 314, the substrate support 130 and the second sliding opening and closing mechanism 158 may be arranged. The first chamber may be arranged on top of the second chamber or vice versa.

According to embodiments that can be combined with any other embodiment described herein, the substrate support 130 may be a support plate, particularly a support plate made of alumina, to support the substrate. Additionally, or alternatively, the substrate support may be a gripping device, e.g. a gripper, for holding and/or transferring the substrate. The substrate includes one or more LEDs, particularly microLEDs, as well as a light-curable ink printed thereon. For example, the light-curable ink may be provided in a pattern on the substrate, e.g. the light-curable ink may be printed on the substrate to provide colored pixels on the substrate. Light-curable ink of different colors may be provided on the substrate, in particular, light-curable ink including a red color, a green color and/or a blue color may be provided. Additionally, or alternatively, a "white" sub-pixel position may be provided. The term "white sub-pixel position" may be understood as a position on the substrate being free from ink. The position may be used for reworking, e.g. in case of LED defects and/or other issues resulting in a defective LED or ink layer on the substrate. According to embodiments, for each pixel, one sub-pixel position may be provided. The light-curable ink may be a quantum dot-based ink and/or an UV-curable ink, i.e. an ink that can be cured with a wavelength in the UV light spectrum. The LEDs may be configured to provide a wavelength between 200 nm and 450 nm to the substrate for curing the light-curable ink. According to embodiments the light-curable ink may be a quantum dot ink.

According to embodiments that can be combined with any other embodiment described herein, the substrate support 130 may include one or more holding arrangements to hold the substrate at the substrate support. The holding arrangement may include mechanical arrangements, magnetic arrangements, pressure arrangements or combinations thereof or the like to hold the substrate at the substrate support. The substrate may include fitting elements to be in contact with the holding arrangement of the substrate support such as magnets, hooks, etc.

According to embodiments that can be combined with any other embodiment described herein, the substrate may have a dimension in the range of 500 mm x 200 mm, particularly in the range of 400 mm x 220 mm, more particularly in the range of 320 mm x 240 mm. The substrate may include a thickness of between 2 mm and 0.1 mm, particularly between 1 mm and 0.3 mm, more particularly of 0.5 mm. The substrate may include a glass substrate. The substrate may further include a polymeric material. The substrate may be made of a polymeric material. The substrate may include and/or be made of a flexible polymeric material. It is to be understood that the apparatus may be configured to process substrates of different sizes and/or thicknesses and/or made of different materials.

According to embodiments that can be combined with any other embodiment described herein, the interface may contact the substrate, i.e. the interface may contact the LEDs on the substrate. As can be exemplarily seen in FIG. 3, the transfer device may change or alter the relative position of the interface and the substrate support and/or may provide a translational movement to the interface and/or the substrate support, in particular, to lower the position of the interface and/or raise the position of the substrate support for contacting the substrate provided on the substrate support below the interface. It is to be understood that the interface and the substrate support may be arranged vice versa, i.e. that the substrate support may be arranged above the interface.

According to embodiments that can be combined with any other embodiment described herein, the interface may include a probe card. The interface or the probe card may include one or more pins for connecting the interface or the probe card to the substrate, i.e. to the LEDs on the substrate for providing power to the LEDs. Thus, the LEDs can be illuminated. The LEDs may be configured to cure the light-curable ink printed onto the substrate. Accordingly, self-curing LEDs can be provided.

According to embodiments that can be combined with any other embodiment described herein, the LEDs may include electrically contactable elements for receiving power to illuminate the LEDs. The LEDs may be interconnected with the one or more electrically contactable elements. The one or more pins may electrically contact the one or more electrically contactable elements of the LEDs. Thus, the LEDs may be illuminated to provide a wavelength within a UV wavelength spectrum to cure the light-curable ink, e.g. UV-curable ink, on the substrate.

According to embodiments that can be combined with any other embodiment described herein, the interface and the substrate support may be integrally formed or may be connected. The substrate support may include the interface or vice versa. For example, the substrate support may include one or more substrate support pins for contacting the LEDs and to provide power to the LEDs. The one or more substrate support pins may contact the electrically contactable elements of the LEDs. Furthermore, the one or more substrate support pins may contact the one or more electrically contactable elements interconnecting the LEDs. Additionally, a further interface may be provided. The further interface may improve electrical contact of the substrate support pins and the LEDs, i.e. the electrically contactable elements of the LEDs.

Advantageously, by providing power to the LEDs, the LEDs may initiate curing of the light-curable ink. The light-curable ink may include a photoinitiator that enables curing upon excitation with light at a determined wavelength. When the LEDs are powered, a polymerization reaction of the photoinitiator may be initiated. Further advantageously, by providing power to the LEDs, the LEDs can be functionally checked, i.e. a functionality test of the LEDs can be provided. Accordingly, the apparatus can be used for both, curing the light-curable ink on the substrate and for checking the functionality of the LEDs simultaneously.

Advantageously, the apparatus according to any of the embodiments described herein provides for efficient curing of light-curable ink. The apparatus can be used in various applications and may achieve energy saving, accurate and precise curing as well as high curing rates. By using the LEDs present on the substrate for providing specific wavelengths for curing, "self-curable" LEDs can be provided.

According to embodiments that can be combined with any other embodiment described herein, the LEDs may be provided on a surface plane of the substrate. The light-curable ink may be provided on a surface plane of the LEDs. Accordingly, the light-curable ink may be a printed layer above a layer providing the LEDs. The electrically contactable elements may be contactable at the surface plane of the substrate and/or from a plane opposing the surface plane, i.e. a bottom plane of the substrate.

According to embodiments that can be combined with any other embodiment described herein, the apparatus may further include a controller. The controller may be configured to control a wavelength provided by the LEDs. For example, the controller may be configured to control the power provided to the LEDs. Additionally, or alternatively, the controller may be configured to selectively regulate illumination of the LEDs. Accordingly, single LEDs can be switched on and/or switched off. Further, the controller may be configured to regulate the temperature inside the apparatus. The controller may include a temperature control for controlling the temperature control element. For example, the controller may regulate the temperature of the cooling plate and/or the cooling gas provided to the apparatus. Additionally, or alternatively, the controller may regulate the flow rate and/or the amount of the cooling gas provided.

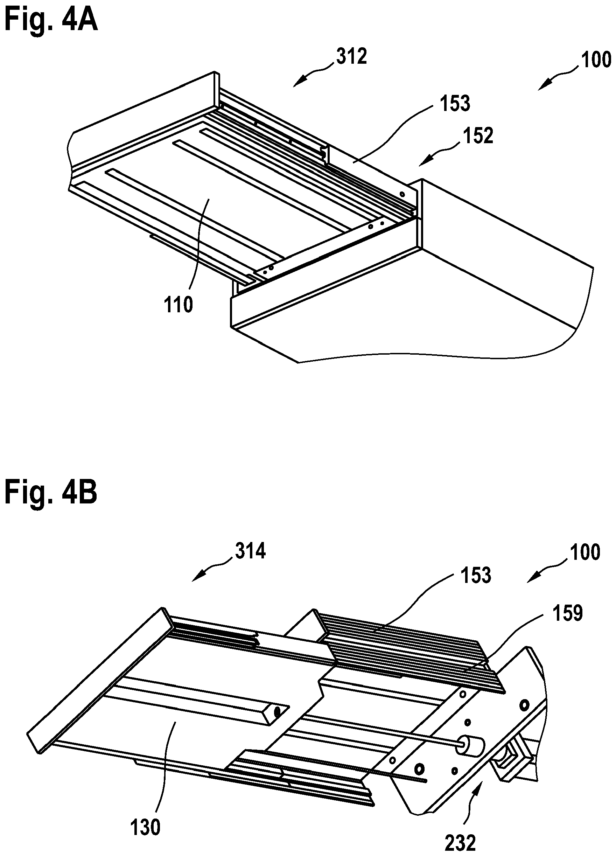

According to embodiments that can be combined with any other embodiment described herein and as exemplarily shown in FIGs. 4A and 4B, the first sliding opening and closing mechanism and the second sliding opening and closing mechanism may be configured to open and close the first chamber 312 and the second chamber 314, respectively. For example, the interface 110 may be connected to the first sliding opening and closing mechanism and the substrate support 130 may be connected to the second sliding opening and closing mechanism such that the interface and/or the substrate support, respectively, can be moved from the inside of the apparatus to a space around the apparatus. Particularly, the first opening and closing mechanism and the second opening and closing mechanism can open and/or close the first chamber and/or the second chamber in a drawer-like manner.

According to embodiments that can be combined with any other embodiment described herein and as exemplarily shown in FIG. 4A, the first sliding opening and closing mechanism 152 may include a first track (not shown) and a second track 153 at which the interface may be provided and/or to which the interface may be secured. Particularly, the interface may be secured to the first track and the second track 153 at a first side and a second side of the interface facing the first side wall and the second side wall of the apparatus 100. The interface may include a corresponding engaging structure to fit onto the first track and/or the second track for enabling a sliding movement of the interface and/or for opening and closing the first chamber 312.

Advantageously, maintenance of the apparatus is facilitated. For example, the interface, i.e. the probe card, and/or the transfer device can be easily exchanged or may be subject to maintenance in place by simply opening the first chamber and exchanging or maintaining the interface and/or the transfer device.

According to embodiments that can be combined with any other embodiment described herein and as exemplarily shown in FIG. 4B, the second sliding opening and closing mechanism 158 may include a first track (not shown) and a second track 159 at which the substrate support 130 may be provided and/or to which the substrate support 130 may be secured. Particularly, the substrate support may be secured to the first track and the second track 159 at a first side and a second side of the substrate support facing the first side wall and the second side wall of the apparatus 100. The substrate support may include a corresponding engaging structure to fit onto the first track and/or the second track for enabling a sliding movement of the substrate support and/or for opening and closing the second chamber 314.

According to embodiments that can be combined with any other embodiment described herein, the first sliding opening and closing mechanism and the second sliding opening and closing mechanism may be driven by an actuator 232. The actuator may act on a pushing device, e.g. a piston or a bar connected to the interface and/or the substrate support to push and/or pull the interface and/or the substrate support for opening and/or closing the first chamber and/or the second chamber as is exemplarily shown in FIG. 4B.

Advantageously, an exchange of the substrate, i.e. loading of a substrate including light-curable ink to be cured and/or unloading of a substrate including cured light-curable ink, can be facilitated. Thus, a cycle time of the apparatus, i.e. the time for a certain number of substrates to be processed, i.e. cured, can be accelerated. Further advantageously, fragile substrates, like glass substrates, can be easily handled and yield can be improved.

According to embodiments that can be combined with any other embodiment described herein, a system 500 for processing a substrate having light emitting diodes (LEDs) is provided. The system 500 may include a printing section 560 for providing a light-curable ink to the substrate and the apparatus according to any of the embodiments described herein. The printing section 560 may include an ink jet printer for providing light-curable ink to the substrate. The printing section 560 may be configured to provide differently colored light-curable inks to the substrate. The printing section may include one or more nozzles for providing the light-curable ink to the substrate.

According to embodiments that can be combined with any other embodiment described herein, the system 500 may include a transporting device 562, particularly a robotic arm, for transporting the substrate from the printing section to the apparatus 100 for curing the light-curable ink printed onto the substrate. The transport device may be configured to load the substrate into and/or unload the substrate from the apparatus. Particularly, the substrate including light-curable ink to be cured may be loaded onto the substrate support and/or the substrate including cured light-curable ink, i.e. a processed substrate, may be unloaded by the transport device 562.

According to embodiments that can be combined with any other embodiment described herein, the transporting device may include a gripper for releasing the first sliding opening and closing mechanism and/or the second sliding opening and closing mechanism. For example, the gripper may pull the substrate support 130 such that the second chamber may open and the transporting device may transport the substrate printed with light-curable ink from the printing section to the apparatus, i.e. the transport device may insert the printed substrate in the second chamber and load the substrate onto the substrate support. The transporting device further may be configured to close the apparatus or the first chamber and/or the second chamber, i.e. to push the substrate support 130 into the apparatus 100 when the substrate has been loaded and/or unloaded.

According to embodiments that can be combined with any other embodiment described herein, the printing section may be configured to provide two or more, particularly three or more, more particularly four or more differently colored light-curable inks to the substrate. Particularly, the printing section may release the light-curable ink onto the surface plane of the substrate. For example, the light-curable ink may be provided in a specific pattern onto the substrate.

According to embodiments that can be combined with any other embodiment described herein, the system may include more than one apparatus for curing the light-curable ink printed onto the substrate. Particularly, the system may include 5 or more apparatuses for curing the light-curable ink printed onto the substrate, more particularly the system may include 10 or more apparatuses for curing the light-curable ink printed onto the substrate. The more than one apparatus for curing the light-curable ink printed onto the substrate may be arranged in parallel and/or in a staggered configuration. For example, the more than one apparatus may be arranged on top of each other. Accordingly, cycle times can be improved, e.g. the cycle time achieved by the system having 10 apparatuses for curing the light-curable ink printed onto the substrate being connected in parallel may be 4 sec or faster.

According to embodiments that can be combined with any other embodiment described herein, the apparatus can be provided as a cassette, particularly a compact cassette to facilitate handling of the curing apparatus and to facilitate exchange or maintenance of the apparatus within the system.

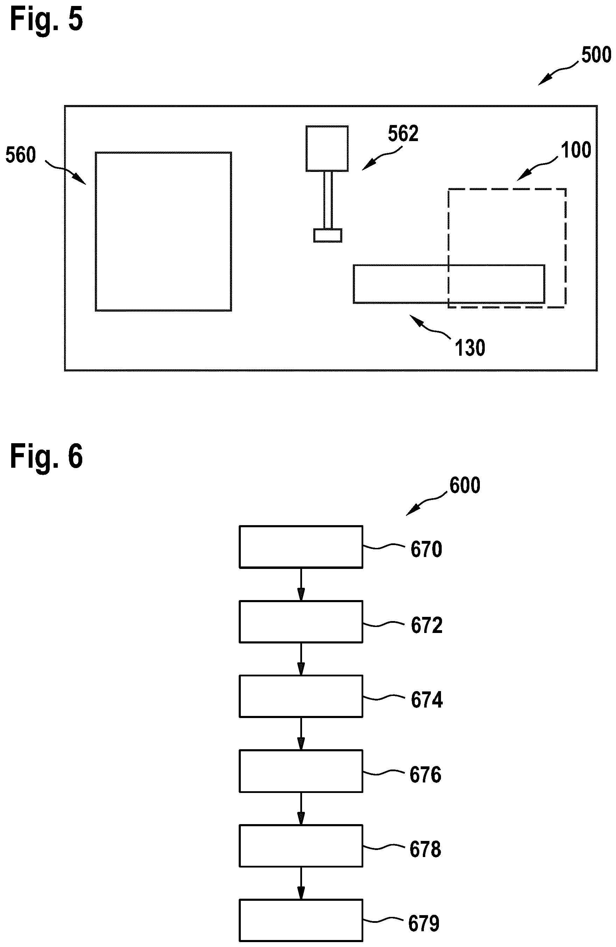

According to embodiments that can be combined with any other embodiment described herein, a method 600 for curing light-curable ink on a substrate having light emitting diodes (LEDs) is provided. The method includes providing (exemplarily indicated by box 670 in FIG. 6) an interface for supplying power to the LEDs. The interface may be configured according to the embodiments described herein. Particularly, the interface may be connected to a power supply. The interface may be provided in a first chamber. The first chamber may be accessible by a first sliding opening and closing mechanism, i.e. the first chamber may be, e.g. opened and closed by the first sliding opening and closing mechanism.

According to embodiments that can be combined with any other embodiment described herein, the method includes providing (exemplarily indicated by box 672 in FIG. 6) the substrate having the LEDs. Providing the substrate may include transporting the substrate from a printing section to an apparatus for curing light-curable ink according to any of the embodiments described herein. The substrate may be provided by a transporting device. For example, the substrate may be loaded and/or unloaded into the apparatus. The substrate may be provided to a substrate support. The substrate support may be provided in a second chamber. The second chamber may be accessible by a second sliding opening and closing mechanism, i.e. the second chamber may be, e.g. opened and closed by the second sliding opening and closing mechanism.

According to embodiments that can be combined with any other embodiment described herein, the method includes contacting (exemplarily indicated by box 674 in FIG. 6) the LEDs with the interface. A translational movement in a vertical direction may be provided to the interface for contacting the LEDs at the substrate. For example, the interface may be moved towards the substrate by a translational movement in a same direction as gravitational forces act on the interface and may be moved away from the substrate by a translational movement in a direction opposite to gravitational forces.

According to embodiments that can be combined with any other embodiment described herein, the method includes providing (exemplarily indicated by box 676 in FIG. 6) a cooling gas for stabilizing a temperature. Particularly, a temperature inside the apparatus for curing light-curable ink may be stabilized. The cooling gas may be provided according to embodiments described herein. Particularly, the cooling gas may circulate through the apparatus for providing a constant temperature to the apparatus.

According to embodiments that can be combined with any other embodiment described herein, the method includes supplying (exemplarily indicated by box 678 in FIG. 6) power to the interface for illuminating the LEDs. The power may be supplied via the interface. The interface may be brought into contact with the substrate, particularly with the LEDs at the substrate. The interface may be connected to a power supply and may transfer energy to the LEDs to illuminate the LEDs. In other words, supplying energy or power to the interface and contacting the LEDs with the interface may lead to providing a specific wavelength by the LEDs to cure the light-curable ink. For example, the interface may be supplied with a DC (direct current) limited to < 100 mA in constant current mode and with a voltage limited to < 5 V.

According to embodiments that can be combined with any other embodiment described herein, the method includes curing (exemplarily indicated by box 679 in FIG. 6) the light-curable ink on the substrate. The light-curable ink may be cured by providing light having a wavelength in the UV spectrum, e.g. from 200 nm to 450 nm. Accordingly, an UV-curable ink may be provided on the substrate. The light for curing may be provided by the LEDs at the substrate. Accordingly, "self-curing" LEDs may be provided for curing light-curable ink printed on the substrate.

According to embodiments that can be combined with any other embodiment described herein, the method may further include applying a force to a transfer device, particularly a pneumatic short stroke cylinder, for changing or altering a relative position of the interface and the substrate support to contact the LEDs on the substrate. The interface may contact the LEDs via the transfer device. In other words, the transfer device may provide a movement to the interface and/or the substrate support for being brought into contact with the substrate, i.e. with the LEDs provided at the substrate.

In view of the above, it is to be understood that compared to the state of the art, embodiments of the present invention beneficially provide for an apparatus for curing light-curable ink, a system for processing a substrate and a method for curing light-curable ink on a substrate which are improved with respect to curing efficiency, temperature stability and curing accuracy in the field of high quality display manufacturing. Further, embodiments described herein beneficially provide for the use of self-curing LEDs, particularly microLEDs, compared to conventional curing apparatuses.

While the foregoing is directed to embodiments of the present invention, other and further embodiments of the present invention may be devised without departing from the the scope thereof as defined by the claims that follow.

## Claims

1. An apparatus (100) comprising a light-sealable housing (105) for curing light-curable ink printed on a substrate (10) having light emitting diodes (LEDs), the apparatus comprising:
an interface (110) for supplying power to the LEDs;
a substrate support (130); and
a transfer device (120) configured to change a relative position of the interface (110) and the substrate support (130),
wherein the transfer device (120) is configured to bring the interface (110) into contact with the substrate (10) for providing the power to the LEDs for illuminating the LEDs to cure the light-curable ink.

2. The apparatus (100) according to claim 1, wherein the apparatus comprises a temperature control element for regulating a temperature inside the apparatus.

3. The apparatus (100) according to claim 2, wherein the temperature control element comprises one selected from the group consisting of a cooling plate and/or a cooling gas conduit,
particularly wherein a temperature provided by the cooling gas conduit is controlled by a flow rate of a cooling gas and/or an amount of the cooling gas provided to the cooling gas conduit.

4. The apparatus (100) according to claim 3, wherein the cooling gas conduit comprises a gas inlet (206) for providing the cooling gas to the apparatus, particularly wherein the cooling gas is an inert gas, more particularly wherein the cooling gas is nitrogen (N2), and wherein the cooling gas conduit comprises a gas outlet (207) for removing the cooling gas from the apparatus.

5. The apparatus (100) according to any of claims 1 to 4, wherein the light-sealable housing (105) comprises inner walls of black color to absorb stray radiation of the LEDs, and/or wherein the apparatus comprises a first sliding opening and closing mechanism (152) and a second sliding opening and closing mechanism (158).

6. The apparatus (100) according to any of claims 1 to 5, wherein the substrate support (130) is a support plate, particularly a support plate made of alumina, to support the substrate.

7. The apparatus (100) according to any of claims 1 to 6, the apparatus further comprising a controller, the controller being configured to control a wavelength provided by the LEDs and/or wherein the controller is configured to selectively regulate illumination of the LEDs.

8. The apparatus (100) according to any of claims 1 to 7, wherein the interface (110) comprises a probe card.

9. The apparatus (100) according to any of claims 1 to 7, wherein the LEDs are provided at a surface plane of the substrate and wherein the light-curable ink is provided on a surface plane of the LEDs.
particularly wherein the LEDs are connected with one or more electrically contactable elements,
more particularly wherein the probe card comprises one or more pins for electrically contacting the one or more electrically contactable elements of the LEDs.

10. The apparatus (100) according to any of claims 1 to 9, wherein the transfer device (130) is one selected from the group consisting of a piston and a short stroke cylinder, particularly wherein the short stroke cylinder is a pneumatic short stroke cylinder.

11. A system (500) for processing a substrate having light emitting diodes (LEDs), the system comprising:
a printing section (560) for providing a light-curable ink to the substrate (10); and
an apparatus (100) according to any of claims 1 to 7,
particularly wherein the system further comprises a transporting device (562), particularly a robotic arm, for transporting the substrate from the printing section (560) to the apparatus for curing light-curable ink.

12. The system (500) according to claim 11, wherein the printing section (560) is configured to provide two or more, particularly three or more, more particularly four or more differently colored light-curable inks.

13. A method (600) for curing light-curable ink on a substrate (10) having light emitting diodes (LEDs), the method comprising:
providing an interface (110) for supplying power to the LEDs;
providing the substrate having the LEDs to a substrate support (130);
changing a relative position of the interface and the substrate support using a transfer device (120);
contacting the LEDs with the interface;
providing a cooling gas for stabilizing a temperature;
supplying power to the interface for illuminating the LEDs; and
curing the light-curable ink on the substrate,
wherein the transfer device brings the interface into contact with the substrate for providing the power to the LEDs for illuminating the LEDs to cure the light-curable ink.

14. The method (600) according to claim 13, wherein the transfer device is a pneumatic short stroke cylinder, the method further comprising:
applying a force to the pneumatic short stroke cylinder for changing a relative position of the interface and the substrate to contact the LEDs on the substrate.

15. The method (600) according to any of claims 13 to 14, wherein the cooling gas is circulated through the apparatus.

## Patentansprüche

1. Vorrichtung (100) umfassend ein lichtdicht verschließbares Gehäuse (105) zum Aushärten von lichthärtender Tinte, die auf ein Substrat (10) mit Leuchtdioden (LEDs) gedruckt ist, wobei die Vorrichtung umfasst:
eine Schnittstelle (110) zur Stromversorgung der LEDs;
einen Substratträger (130); und
eine Übertragungsvorrichtung (120), die so konfiguriert ist, dass sie eine relative Position der Schnittstelle (110) und des Substratträgers (130) ändert,
wobei die Übertragungsvorrichtung (120) so konfiguriert ist, dass sie die Schnittstelle (110) in Kontakt mit dem Substrat (10) bringt, um die LEDs mit Strom zu versorgen und die LEDs zum Aushärten der lichthärtenden Tinte zu illuminieren.

2. Vorrichtung (100) nach Anspruch 1, wobei die Vorrichtung ein Temperatursteuerungselement zur Regulierung einer Temperatur im Inneren der Vorrichtung umfasst.

3. Vorrichtung (100) nach Anspruch 2, wobei das Temperatursteuerungselement eines aus der Gruppe bestehend aus einer Kühlplatte und/oder einer Kühlgasleitung umfasst,
insbesondere wobei die von der Kühlgasleitung gelieferte Temperatur durch die Durchflussrate eines Kühlgases und/oder die Menge des der Kühlgasleitung zugeführten Kühlgases gesteuert wird.

4. Vorrichtung (100) nach Anspruch 3, wobei die Kühlgasleitung einen Gaseinlass (206) zum Zuführen des Kühlgases zu der Vorrichtung umfasst, insbesondere wobei das Kühlgas ein Inertgas ist, insbesondere wobei das Kühlgas Stickstoff (N2) ist, und wobei die Kühlgasleitung einen Gasauslass (207) zum Entfernen des Kühlgases aus der Vorrichtung umfasst.

5. Vorrichtung (100) nach einem der Ansprüche 1 bis 4, wobei das lichtdicht verschließbare Gehäuse (105) Innenwände in schwarzer Farbe aufweist, um Streustrahlung der LEDs zu absorbieren, und/oder
wobei die Vorrichtung einen ersten verschiebbaren Öffnungs- und Schließmechanismus (152) und einen zweiten verschiebbaren Öffnungs- und Schließmechanismus (158) umfasst.

6. Vorrichtung (100) nach einem der Ansprüche 1 bis 5, wobei der Substratträger (130) eine Trägerplatte, insbesondere eine Trägerplatte aus Aluminiumoxid, zum Tragen des Substrats ist.

7. Vorrichtung (100) nach einem der Ansprüche 1 bis 6, wobei die Vorrichtung ferner eine Steuerung umfasst, die so konfiguriert ist, dass sie eine von den LEDs bereitgestellte Wellenlänge steuert und/oder wobei die Steuerung so konfiguriert ist, dass sie die Beleuchtung der LEDs selektiv reguliert.

8. Vorrichtung (100) nach einem der Ansprüche 1 bis 7, wobei die Schnittstelle (110) eine Sondenkarte umfasst.

9. Vorrichtung (100) nach einem der Ansprüche 1 bis 7, wobei die LEDs auf einer Oberflächenebene des Substrats vorgesehen sind und wobei die lichthärtende Tinte auf einer Oberflächenebene der LEDs vorgesehen ist
insbesondere wobei die LEDs mit einem oder mehreren elektrisch kontaktierbaren Elementen verbunden sind,
insbesondere wobei die Sondenkarte einen oder mehrere Stifte zur elektrischen Kontaktierung des einen oder der mehreren elektrisch kontaktierbaren Elemente der LEDs umfasst.

10. Vorrichtung (100) nach einem der Ansprüche 1 bis 9, wobei die Übertragungsvorrichtung (130) aus der Gruppe ausgewählt ist, die aus einem Kolben und einem Kurzhubzylinder besteht, insbesondere wobei der Kurzhubzylinder ein pneumatischer Kurzhubzylinder ist.

11. System (500) zum Verarbeiten eines Substrats mit lichtemittierenden Dioden (LEDs), wobei das System umfasst:
einen Druckabschnitt (560) zum Aufbringen einer lichthärtenden Tinte auf das Substrat (10); und
eine Vorrichtung (100) nach einem der Ansprüche 1 bis 7,
insbesondere wobei das System ferner eine Transportvorrichtung (562), insbesondere einen Roboterarm, zum Transportieren des Substrats von dem Druckabschnitt (560) zu der Vorrichtung zum Aushärten der lichthärtenden Tinte umfasst.

12. System (500) nach Anspruch 11, wobei der Druckabschnitt (560) so konfiguriert ist, dass er zwei oder mehr, insbesondere drei oder mehr, insbesondere vier oder mehr unterschiedlich gefärbte lichthärtende Tinten bereitstellt.

13. Verfahren (600) zum Aushärten von lichthärtender Tinte auf einem Substrat (10) mit lichtemittierenden Dioden (LEDs), wobei das Verfahren umfasst:
Bereitstellen einer Schnittstelle (110) für die Stromversorgung der LEDs;
Bereitstellen des Substrats mit den LEDs auf einem Substratträger (130);
Ändern einer relativen Position der Schnittstelle und des Substratträgers unter Verwendung einer Übertragungsvorrichtung (120);
Kontaktierung der LEDs mit der Schnittstelle;
Bereitstellen eines Kühlgases zur Stabilisierung einer Temperatur;
Zuführen von Strom zur Schnittstelle, um die LEDs zu beleuchten; und
Aushärten der lichthärtenden Tinte auf dem Substrat,
wobei die Übertragungsvorrichtung die Schnittstelle mit dem Substrat in Kontakt bringt, um die LEDs mit Strom zu versorgen, um die LEDs zum Aushärten der lichthärtenden Tinte zu beleuchten.

14. Verfahren (600) nach Anspruch 13, wobei die Übertragungsvorrichtung ein pneumatischer Kurzhubzylinder ist, wobei das Verfahren ferner umfasst:
Aufbringen einer Kraft auf den pneumatischen Kurzhubzylinder, um eine relative Position der Schnittstelle und des Substrats zu verändern, um die LEDs auf dem Substrat zu kontaktieren.

15. Verfahren (600) nach einem der Ansprüche 13 bis 14, wobei das Kühlgas durch die Vorrichtung zirkuliert wird.

## Revendications

1. Appareil (100) comprenant un logement (105) étanche à la lumière pour le durcissement d'encre durcissable à la lumière imprimée sur un substrat (10) ayant des diodes électroluminescentes (DEL), l'appareil comprenant :
une interface (110) permettant de fournir de la puissance aux DEL ;
un support de substrat (130) ; et
un dispositif de transfert (120) configuré pour changer une position relative de l'interface (110) et du support de substrat (130),
dans lequel le dispositif de transfert (120) est configuré pour amener l'interface (110) en contact avec le substrat (10) pour la fourniture de la puissance aux DEL pour illuminer les DEL pour durcir l'encre durcissable à la lumière.

2. Appareil (100) selon la revendication 1, dans lequel l'appareil comprend un élément de commande de température permettant de réguler une température à l'intérieur de l'appareil.

3. Appareil (100) selon la revendication 2, dans lequel l'élément de commande de température comprend l'un choisi dans le groupe constitué par une plaque de refroidissement et/ou un conduit de gaz de refroidissement, en particulier dans lequel une température fournie par le conduit de gaz de refroidissement est commandée par un débit d'un gaz de refroidissement et/ou une quantité du gaz de refroidissement fourni au conduit de gaz de refroidissement.

4. Appareil (100) selon la revendication 3, dans lequel le conduit de gaz de refroidissement comprend une entrée de gaz (206) permettant de fournir le gaz de refroidissement à l'appareil, en particulier dans lequel le gaz de refroidissement est un gaz inerte, plus particulièrement dans lequel le gaz de refroidissement est de l'azote (N2), et dans lequel le conduit de gaz de refroidissement comprend une sortie de gaz (207) permettant de retirer le gaz de refroidissement de l'appareil.

5. Appareil (100) selon l'une quelconque des revendications 1 à 4, dans lequel le logement (105) étanche à la lumière comprend des parois internes de couleur noire pour absorber un rayonnement parasite des DEL, et/ou dans lequel l'appareil comprend un premier mécanisme coulissant d'ouverture et
fermeture (152) et un second mécanisme coulissant d'ouverture et
fermeture (158).

6. Appareil (100) selon l'une quelconque des revendications 1 à 5, dans lequel le support de substrat (130) est une plaque de support, en particulier une plaque de support constituée d'alumine, pour supporter le substrat.

7. Appareil (100) selon l'une quelconque des revendications 1 à 6, l'appareil comprenant en outre un dispositif de commande, le dispositif de commande étant configuré pour commander une longueur d'onde fournie par les DEL et/ou dans lequel le dispositif de commande est configuré pour réguler sélectivement l'illumination des DEL.

8. Appareil (100) selon l'une quelconque des revendications 1 à 7, dans lequel l'interface (110) comprend une carte sonde.

9. Appareil (100) selon l'une quelconque des revendications 1 à 7, dans lequel les DEL sont fournies au niveau d'un plan de surface du substrat et dans lequel l'encre durcissable à la lumière est fournie sur un plan de surface des DEL.
en particulier dans lequel les DEL sont connectées à un ou plusieurs éléments à contact électrique,
plus particulièrement dans lequel la carte sonde comprend une ou plusieurs broches permettant de mettre en contact électrique le ou les éléments à contact électrique des DEL.

10. Appareil (100) selon l'une quelconque des revendications 1 à 9, dans lequel le dispositif de transfert (130) est l'un choisi dans le groupe constitué par un piston et un cylindre à course courte, en particulier dans lequel le cylindre à course courte est un cylindre pneumatique à course courte.

11. Système (500) permettant de traiter un substrat ayant des diodes électroluminescentes (DEL), le système comprenant :
une section d'impression (560) permettant de fournir une encre durcissable à la lumière au substrat (10) ; et
un appareil (100) selon l'une quelconque des revendications 1 à 7,
en particulier dans lequel le système comprend en outre un dispositif de transport (562), en particulier un bras robotisé, permettant de transporter le substrat de la section d'impression (560) à l'appareil pour le durcissement de l'encre durcissable à la lumière.

12. Système (500) selon la revendication 11, dans lequel la section d'impression (560) est configurée pour fournir deux des encres durcissables à la lumière de couleurs différentes ou plus, en particulier trois ou plus, plus particulièrement quatre ou plus.

13. Procédé (600) pour le durcissement d'une encre durcissable à la lumière sur un substrat (10) ayant des diodes électroluminescentes (DEL), le procédé comprenant :
la fourniture d'une interface (110) permettant de fournir de la puissance aux DEL ;
la fourniture du substrat ayant les DEL à un support de substrat (130) ;
le changement d'une position relative de l'interface et du support de substrat à l'aide d'un dispositif de transfert (120) ;
la mise en contact des DEL avec l'interface ;
la fourniture d'un gaz de refroidissement pour stabiliser une température ;
l'alimentation en puissance de l'interface pour illuminer les DEL ; et
le durcissement de l'encre durcissable à la lumière sur le substrat,
dans lequel le dispositif de transfert amène l'interface en contact avec le substrat pour fournir la puissance aux DEL pour illuminer les DEL pour durcir l'encre durcissable à la lumière.

14. Procédé (600) selon la revendication 13, dans lequel le dispositif de transfert est un cylindre pneumatique à course courte, le procédé comprenant en outre :
l'application d'une force au cylindre pneumatique à course courte pour changer une position relative de l'interface et du substrat pour venir en contact avec les DEL sur le substrat.

15. Procédé (600) selon l'une quelconque des revendications 13 à 14, dans lequel le gaz de refroidissement est mis en circulation à travers l'appareil.
